# EUROPEAN PATENT APPLICATION

(11) **EP 4 722 408 A1**
(43) Date of publication of application: **08.04.2026**
(21) Application number: 25174565.9
(22) Date of filing: 06.05.2025
(51) Int. Cl.: C23C 14/24, C01B 21/064, C04B 35/583, C23C 14/30, C23C 16/26, C30B 23/06, C30B 25/02, B32B 18/00, C30B 35/00

(54) **PBN CONTAINER AND METHOD FOR PRODUCING PBN CONTAINER**

(30) Priority: 04.10.2024 JP 2024174779
(71) Applicant: Shin-Etsu Chemical Co., Ltd., Tokyo 100-0005 (JP)
(72) Inventor: Hirate, Akihiro, Gunma (JP); Kimura, Noboru, Gunma (JP); Kushihashi, Takuma, Gunma (JP); Kano, Shoji, Gunma (JP); Yamamura, Waichi, Gunma (JP)
(74) Representative: Schicker, Silvia

(57) **Abstract**

The present invention is a PBN container including a container body made of a laminate of pyrolytic boron nitride, and a conductive film coating a surface of the container body, in which an angle θ between a cut face of the container body and an inner wall surface or an outer wall surface of the container body adjacent to the cut face is 20° or more and 80° or less across an entire circumference of an aperture of the container body, and a tip portion of the aperture of the container body has a shape having a curvature radius R of 0.2 mm or more and 3.0 mm or less across the entire circumference of the aperture of the container body. This provides the PBN container excellent in durability where the conductive film is laminated on a surface of the container body formed by depositing PBN, and the method for producing such a PBN container.

## Description

### TECHNICAL FIELD

The present invention relates to a PBN container and a method for producing a PBN container.

### BACKGROUND ART

PBN (pyrolytic boron nitride) is manufactured by using a pyrolysis method. Therefore, PBN has a kind of laminar film structure in a microscopical view. PBN has anisotropy between a surface direction and a thickness direction of the laminar film. Such PBN has various advantages in that a container of high purity can be easily formed by a CVD method, contamination derived from the container can be prevented, and so on. Therefore, PBN has been used as material for various containers such as a hearth liner for electron beam evaporation, a container for MBE (molecular beam epitaxy), a container for metal melting, and a container for analysis.

Here, a hearth liner for electron beam evaporation is quoted as an example of a PBN container and is described below. Electron beam evaporation is a useful method for forming a thin film on a substrate. In electron beam evaporation, an electron beam is irradiated into evaporation material, thereby heating and evaporating the material, and the evaporated material is deposited onto the substrate, and thus, a thin film is formed on the substrate (see, for example, Non Patent Document 1). For example, a hearth liner for electron beam evaporation is put in a water-cooled copper crucible (hearth), the electron beam is irradiated into evaporation material filled in the hearth liner by an electron gun, and thereby the evaporation material is evaporated.

In this case, the evaporation material can also be directly filled in a hearth without using the hearth liner for electron beam evaporation to fill the evaporation material. However, a hearth liner can be brought out to clean, so cleaning is easy. In addition, when it is desired that a different evaporation material is deposited onto a substrate, hearth liners may be merely exchanged, so the operation is simple, and contamination can also be prevented. Therefore, the hearth liner for electron beam evaporation is generally used.

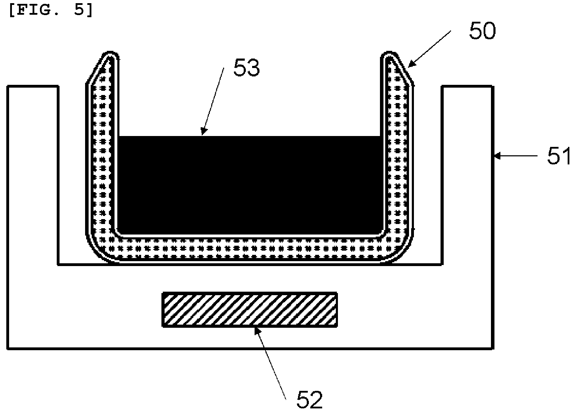

FIG. 5 is a schematic sectional view illustrating one example of a hearth liner for electron beam evaporation and a hearth. This hearth liner 50 for electron beam evaporation (PBN container) is put in a copper hearth 51, and the bottom contacts with the hearth 51. The hearth 51 is cooled by cooling water 52. Moreover, evaporation material 53 such as aluminum is filled in the hearth liner 50 as shown in FIG. 5.

As such a hearth liner for electron beam evaporation, it is also known that it is made of carbon as well as PBN. However, there is a problem in which the hearth liner made of carbon reacts with the evaporation material. For example, if electron beam evaporation is performed by filling aluminum in the hearth liner made of carbon, carbon and aluminum react to generate aluminum carbide (Al₄C₃). Therefore, a thin film of aluminum deposited onto a substrate is degraded in crystallinity and purity.

On the contrary, the hearth liner made of PBN has an advantage in that it is hard to react with an evaporation material. However, even if the hearth liner made of PBN is used, there is a problem as follows. Firstly, an evaporation material can be merely partially melted in the extreme vicinity where the electron beam is irradiated, and it is impossible to melt the evaporation material wholly. Moreover, if aluminum is used as an evaporation material, aluminum crawls up along the inner wall surface of the hearth liner by surface tension, and thereby, it is difficult to view a melted state, and a state of the melted spot is bad. Further, because PBN is an insulator, charge-up is caused by irradiating the electron beam. Because of these reasons, uniform high-purity metal films of large area could not be stably made.

To solve this problem, a PBN hearth liner in which a conductive film is laminated on a surface of the container body formed by depositing PBN has been developed (see, for example, Patent Document 1). Because the conductive film is heated by the electron beam in the case of using this PBN hearth liner, an evaporation material can be wholly melted. Further, because there is a conductive film, the problem of charge-up is not caused. Further, it becomes difficult for a melted evaporation materials such as aluminum to crawl up along the inner wall surface of the hearth liner. Therefore, it was believed that uniform high-purity metal films of large area could be stably made by using this PBN hearth liner.

However, the hearth liner, coated with the conductive film on the surface of the container body formed by depositing PBN, has a problem of being prone to breakage and resulting in a short lifespan. Therefore, the PBN container such as a PBN hearth liner having excellent durability has been desired.

### CITATION LIST

### PATENT LITERATURE

Patent Document 1: JP H9-59766 A
Patent Document 2: JP 2006-104554 A

### NON PATENT LITERATURE

Non Patent Document 1: "Handbook of Thin Film Engineering", published by Ohm Company, p 101-p 105, published on Dec. 10, 1983 (Showa 58)

### SUMMARY OF INVENTION

### TECHNICAL PROBLEM

The present invention has been made in view of the aforementioned problems, and its object is to provide a PBN container excellent in durability where a conductive film is laminated on a surface of a container body formed by depositing PBN, and the method for producing such a PBN container.

### SOLUTION TO PROBLEM

To achieve the object, the present invention provides a PBN container comprising:
a container body made of a laminate of pyrolytic boron nitride (PBN); and
a conductive film coating a surface of the container body, wherein
an angle θ between a cut face of the container body and an inner wall surface or an outer wall surface of the container body adjacent to the cut face is 20° or more and 80° or less across an entire circumference of an aperture of the container body, and
a tip portion of the aperture of the container body has a shape having a curvature radius R of 0.2 mm or more and 3.0 mm or less across the entire circumference of the aperture of the container body.

Such a PBN container, due to a shape thereof, can make the conductive film less likely to peel off and more durable.

In this case, the inventive PBN container is preferably a PBN container in which the tip of the aperture of the container body has a flat surface and the flat surface in a radial direction of the container body has a length of 0.05 mm or more and 2 mm or less.

By having such a flat surface, the PBN container can make the conductive film even less likely to peel off and improve durability.

Moreover, it is preferable that the container body has a density of 1.7 g/cm³ or more and 2.2 g/cm³ or less.

By using the container body of such a density, it becomes difficult for melted metal material (for example, evaporation materials such as aluminum) to penetrate the PBN layer, thereby improving durability.

Moreover, surface roughness Ra of the container body is preferably in a range of 0.5 µm or more and 5.0 µm or less.

By setting the surface roughness as such, the surface tension can be optimized. As a result, for example, it becomes difficult for the metal material (for example, the evaporation materials such as aluminum) to crawl up along the inner wall surface of the PBN container.

Moreover, it is preferable that the surface roughness Ra on the outer wall side of the container body is smaller than the surface roughness Ra on the inner wall side of the container body.

In this way, even when the metal material (for example, the evaporation materials such as aluminum) crawls up along the inner wall surface of the PBN container, it can be prevented from leaking out to the outer wall surface.

Moreover, an angle θ' between the inner wall surface or the outer wall surface of the container body and an axis of symmetry of the container body is preferably 0.5° or more and 60° or less.

By having such a shape, an amount of metal material (for example, the evaporation materials such as aluminum) that crawls up the inner wall surface of the PBN container can be optimized thus improving quality of products.

Moreover, the PBN container is preferably a PBN hearth liner for electron beam evaporation.

The inventive PBN container has excellent durability, as described above. Therefore, if the PBN container is used as the PBN hearth liner for electron beam evaporation, uniform high-purity metal films of large-area can be made for a long time. In addition, because the PBN container is hardly broken and has a long life, the frequency of exchanges of the container can be decreased without reducing an availability ratio of the apparatus. Thus, a cost-reduction effect can be obtained.

Moreover, the conductive film is preferably pyrolytic graphite (PG).

Pyrolytic graphite (PG), like PBN, can easily be made into a high-purity PG film by a CVD method, etc., and it hardly reacts with a filled material such as a melted metal. Also, PG has excellent electrical conductivity. From these, PG is suitable as the conductive film.

Moreover, it is preferable that the conductive film has a thickness of 5 µm or more and 100 µm or less.

By having the conductive film with such a film thickness, the durability and yield of the container can be improved.

Moreover, the present invention provides a method for producing a PBN container, the method comprising the steps of:
forming a container body by laminating pyrolytic boron nitride and processing a shape thereof; and
laminating a conductive film on a surface of the container body, wherein
in the step of forming a container body, an angle θ between a cut face of the container body and an inner wall surface or an outer wall surface of the container body adjacent to the cut face is 20° or more and 80° or less across an entire circumference of an aperture of the container body, and a tip portion of the aperture of the container body has a shape having a curvature radius R of 0.2 mm or more and 3.0 mm or less across the entire circumference of the aperture of the container body.

Such a method for producing a PBN container can produce the PBN container in which the conductive film is less likely to peel off and more durable.

In this case, the PBN container to be produced is preferably a PBN hearth liner for electron beam evaporation.

In this way, the inventive method for producing a PBN container can be suitably adopted to produce the PBN hearth liner for electron beam evaporation.

Moreover, the conductive film is preferably pyrolytic graphite.

PG, like PBN, can easily be made into a high-purity PG film by the CVD method, etc., and it hardly reacts with the filled material such as melted metal. Also, PG has excellent electrical conductivity. From these, PG is suitable as the conductive film.

### ADVANTAGEOUS EFFECTS OF INVENTION

As described above, according to the inventive PBN container and the inventive method for producing such a PBN container, the container formed by depositing PBN, in which a conductive film is laminated on a surface of a container body, has an angle θ between a cut face of the container body and at least one wall surface adjacent to the cut face is 20° or more and 80° or less and has a shape having a curvature radius R of 0.2 mm or more and 3.0 mm or less at a tip portion of the aperture of the container body. Consequently, residual stress is hardly caused while using the PBN container, and the container is hardly damaged. Therefore, the present invention can provide the PBN container with excellent durability.

### BRIEF DESCRIPTION OF DRAWINGS

FIG. 1 is a schematic view illustrating one example of a PBN container (hearth liner for electron beam evaporation) of the present invention. (a) is a sectional view, and (b) is an enlarged view thereof.
FIG. 2 is a schematic cross-sectional view illustrating another example of a PBN container (hearth liner for electron beam evaporation) of the present invention.
FIG. 3 is a schematic cross-sectional view illustrating further alternative example of a PBN container (hearth liner for electron beam evaporation) of the present invention.
FIG. 4 is an explanatory view illustrating a method for producing a PBN container of the present invention.
FIG. 5 is a schematic cross-sectional view illustrating one example of a typical hearth liner for electron beam evaporation, and a typical hearth.

### DESCRIPTION OF EMBODIMENTS

Hereinafter, the present invention will be described.

Coefficients of thermal expansion are very different between PBN and a conductive film. Consequently, when an angle between a cut face of a container body made of PBN and a wall surface is about 90°, as in a general PBN container, residual stress between PBN and the conductive film works at the cut face by heating and cooling, thereby causing a stress that peels off the conductive film from the PBN. Therefore, while the container is repeatedly heated and cooled, peeling progresses, a melted evaporation material crawls up and seeps in, and the container is then damaged. However, the PBN container, as in Patent Document 2, is designed such that an angle between the cut face of the body and at least one wall surface adjacent to the cut face is 20° to 80°. Therefore, the apparent coefficient of thermal expansion of PBN is decreased at the cut face, and even when heating and cooling of the container are repeated, the residual stress hardly occurs, and the container is not damaged for a long time. In the inventive PBN container, it is found that, in addition to the above shape, the conductive film becomes more resistant to peeling and thus enhancing durability by forming the shape in which the tip of the aperture of the container is included within a range of R of 0.2 mm or more and R of 3.0 mm or less across the entire circumference of the aperture of the container.

That is, the inventive PBN (pyrolytic boron nitride) is a PBN container comprising:
a container body made of a laminate of pyrolytic boron nitride; and
a conductive film coating a surface of the container body, wherein
an angle θ between a cut face of the container body and an inner wall surface or an outer wall surface of the container body adjacent to the cut face is 20° or more and 80° or less across an entire circumference of an aperture of the container body, and
a tip portion of the aperture of the container body has a shape having a curvature radius R of 0.2 mm or more and 3.0 mm or less across the entire circumference of the aperture of the container body.

Such an inventive PBN container is obtained based on the following findings. The present inventors have earnestly studied to improve the durability of the PBN container, in which the container body, formed by laminating PBN, has the conductive film laminated on the surface thereon.

Here, for example, PG (pyrolytic graphite) can be exemplified as the conductive film. Coefficients of thermal expansion are very different between PG used as the conductive film and PBN used as the container body. In addition, it is known that PBN in itself has a large difference in coefficient of thermal expansion between a surface direction and a thickness direction.

Coefficients of thermal expansion of PBN and PG are shown as follows.
Expansion coefficient of PG: 2×10⁻⁶ [/°C]
Expansion coefficient of a surface direction of PBN: 3×10-6 [/°C]
Expansion coefficient of a thickness direction of PBN: 25×10⁻⁶ [/°C]

In the case that the coefficients of thermal expansion are largely different as described above, the following problems will be caused. Namely, in the case of a PBN container in which an angle between a cut face (a sectioned surface in a thickness direction) of the container body and a wall surface adjacent to the cut face is about 90° as conventional when the PBN container is cooled down to room temperature after heating, a strong residual stress is caused in the cut face because expansion coefficient of the cut face is large. Consequently, the residual stress causes peeling off to progress after several uses, and the melted evaporation material crawls up and seeps in, causing damage at the aperture. This was the cause of the short lifespan of the PBN container.

Accordingly, as a result of the diligent studies, the present inventors conceived that to prevent the residual stress from occurring, the cut face of the body should be cut at an angle so that an angle between the cut face and at least one wall surface adjacent to the cut face becomes 20° to 80°, and the tip portion of the aperture of the container is formed in the shape which is included within a range of R of 0.2 mm or more and R of 3.0 mm or less across the entire circumference of the aperture of the container, and an apparent coefficient of linear expansion of the cut face is then less than 25×10⁻⁶ [/°C]. This leads to the completion of the present invention.

Hereinafter, embodiments of the present invention will be explained with reference to the drawings, but the present invention is not limited thereto.

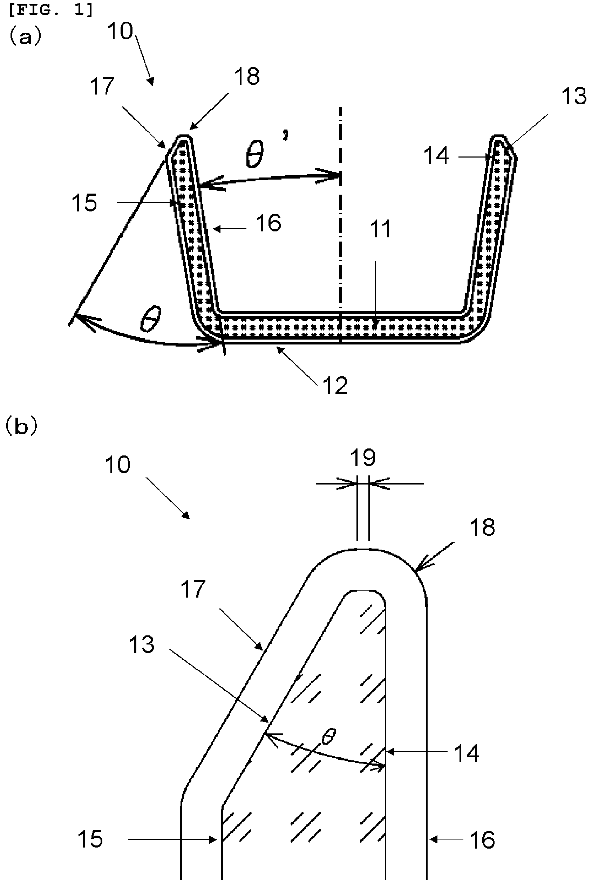

FIG. 1 shows a sectional view of one example of a PBN container of the present invention. This FIG. 1 shows, more specifically, one example of a hearth liner for electron beam evaporation as a PBN container. FIG. 1 (a) is a sectional view, and FIG. 1 (b) is an enlarged view of the container.

A PBN container (hearth liner) 10 shown in FIG. 1 includes a container body 11 composed of a laminate of PBN and a conductive film 12 coating a surface of the container body 11. That is, the container has the conductive film 12 laminated on the surface of the container body 11 that is formed by laminating PBN. Moreover, in a cut face 13 of the container body 11, and an inner wall surface 14 or an outer wall surface 15 of the container body 11 adjacent to the cut face 13; an angle θ between the inner wall surface 14 and the cut face 13 is 20° or more and 80° or less across an entire circumference of an aperture of the container body 11. In this case, an angle between an inner wall surface 16 and an upper end surface 17 of the container 10 coated with the conductive film 12 is also substantially the same as θ, which is 20° to 80°. By forming such a shape, apparent thermal expansion coefficient of PBN is reduced, making residual stress less likely to occur at the cut face portion even after repeated heating and cooling of the container.

Moreover, as shown in FIG. 1, a portion at the tip of the aperture of the container body 11 (a portion 18 on an inner wall side of the tip of the aperture of the container in FIG. 1) has a shape having a curvature radius R of 0.2 mm or more and 3.0 mm or less across an entire circumference of the aperture of the container body. In this way, by making the portion 18 on the inner wall side of the tip of the aperture of the container R-shape, the apparent thermal expansion coefficient of PBN is reduced. As a result, even after repeated heating and cooling of the container, the residual stress hardly occurs, and the container is not damaged for a long time. The R-shape here has a curvature radius of 0.2 mm or more and 3 mm or less; in particular, that of 0.3 mm or more and 1 mm or less is preferable, and that of 0.75 mm or less is further preferable.

In the inventive PBN container 10 having the above shape, the conductive film 12 is more resistant to peeling and thus more durable. That is, the apparent coefficient of thermal expansion of PBN is decreased, and even when heating and cooling of the container are repeated, the residual stress hardly occurs at the cut face, and the container is not damaged for a long time. As a result, it becomes the container excellent in durability. Therefore, if electron beam evaporation is performed using this hearth liner for electron beam evaporation, stable film growth can be performed for a long time. In addition, because it is hardly damaged and has a long life, a decrease in an availability ratio of the apparatus due to exchanges of it is prevented. Thus, cost reduction effect is obtained.

In the inventive PBN container 10, as shown in FIG. 1, the angle θ between the cut face 13 of the container body 11 and the inner wall surface 14 adjacent to the cut face 13 is preferably 20° to 80°. When a material is filled in the container 10, filled material such as melted metal occasionally crawls up along the inner wall surface of the PBN container 10 due to surface tension and such, and leaks out. However, when an angle between the cut face 13 and the inner wall surface 14 adjacent to the cut face 13 is 20° to 80° as in the present invention shown in FIG. 1, it becomes difficult for the filled material to crawl up along the inner wall of the PBN container 10, and the filled material can be more effectively prevented from leaking out of the PBN container 10.

However, the angle θ between the outer wall surface 15 and the cut face 13, among the cut face 13 of the container body 11 and the inner wall surface 14 or the outer wall surface 15 of the container body 11 adjacent to the cut face 13, may be 20° or more and 80° or less across an entire circumference of the aperture of the container body 11. In this case, although an effect of preventing leakage of the filled material is absent, the same effect of preventing, e.g., damage, can be obtained as described above, resulting in a highly durable PBN container 10.

In the inventive PBN container 10, by making the angle θ between the cut face 13 of the container body 11 and the inner wall surface 14 or the outer wall surface 15 of the container body 11 adjacent to the cut face 13 (that is, substantially the same angle between the inner wall surface 16 and the upper end surface 17 of the PBN container 10) to be 50° or less, the occurrence of stress can be more reliably suppressed. On the other hand, by setting the angle θ to 40° or more, mechanical strength of the PBN container 10 after the angle cut can be kept more sufficiently. Accordingly, it is more preferable that an angle θ is from 40° or more and 50° or less.

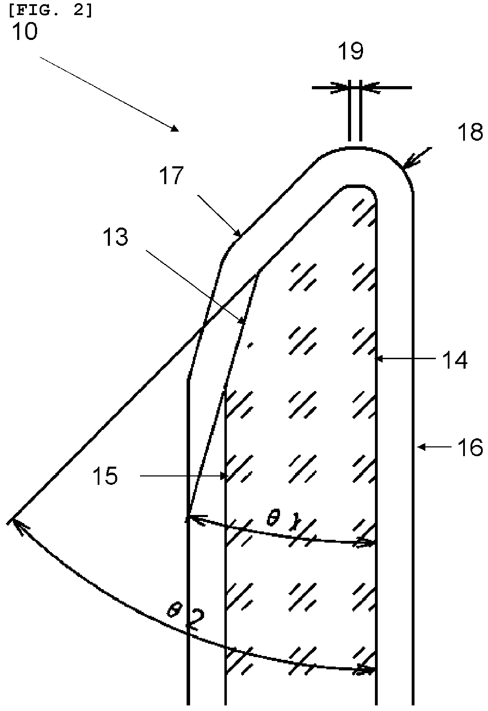

Moreover, as shown in FIG. 2, the angle may be changed to be sharper from a midway point of the cut face 13. Although FIG. 2 shows θ1 and θ2, it is preferable to set the angle θ2 between the cut face 13 and the wall surface (inner wall surface 14 or outer wall surface 15) after changing the angle from 20° to 80°.

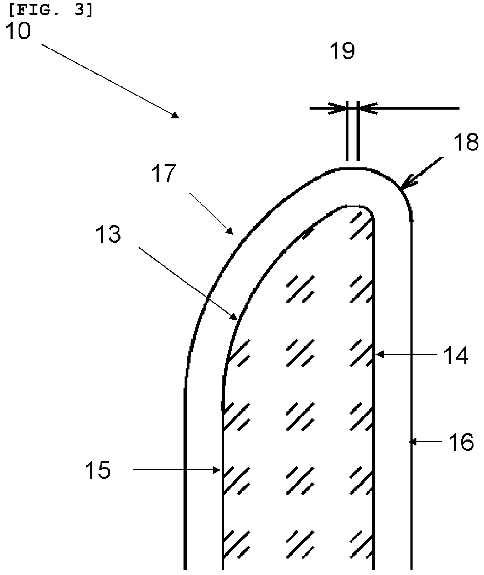

Moreover, as shown in FIG. 3, the cut face 13 (upper end surface 17) may be an arc with a continuously changing angle (R shape: for example, a curvature radius of around R 10 mm to R 1000 mm).

Moreover, in the inventive PBN container, as shown in FIG. 1 (b), it is preferable that the tip of the aperture of the container body 11 has a flat surface 19 and the flat surface 19 in a radial direction of the container body 11 has a length of 0.05 mm or more and 2 mm or less. By forming such a shape, the conductive film 12 is more resistant to peeling, thus more durable. Moreover, processing time during production can be shortened, and productivity improvement can be expected. The length of the flat surface 19 in the radial direction is preferably 0.05 mm or more and 2 mm or less as described above, more preferably 0.1 mm or more and 1 mm or less, and particularly preferably 0.2 mm or more and 0.5 mm or less.

In the inventive PBN container 10, it is preferable that the container body has a density of 1.7 g/cm³ or more and 2.2 g/cm³ or less. By having such a density, it becomes difficult for melted metal material (for example, evaporation materials such as aluminum) to penetrate the PBN layer of the container body 11, thereby improving durability. The density of the container body 11 is preferably in a range of 1.7 g/cm³ or more and 2.2 g/cm³ or less as described above, more preferably 1.8 g/cm³ or more and 2.15 g/cm³ or less, and particularly preferably 1.9 g/cm³ or more and 2.1 g/cm³ or less.

Moreover, it is preferable that surface roughness Ra of the container body 11 is in a range of 0.5 µm or more and 5.0 µm or less. When a material is filled in a conventional PBN container, the filled material such as melted metal occasionally crawls up along the inner wall surface of the container due to surface tension and such and leaks out. However, in the inventive PBN container 10, by setting the surface roughness of the container body 11 in the above range, the surface tension is optimized, and it becomes difficult for the evaporation materials such as melted aluminum to crawl up along the inner wall of the PBN container 10 (hearth liner). It is preferable that surface roughness Ra of the container body 11 is 0.5 µm or more and 5.0 µm or less, as described above, more preferably 1.0 µm or more and 3.0 µm or less, and particularly preferably 1.5 µm or more and 2.5 µm or less.

Moreover, in the inventive PBN container 10, it is preferable that the surface roughness Ra on the outer wall side of the container body 11 is smaller than the surface roughness Ra on the inner wall side of the container body 11. This can suppress the leaking out of the evaporation materials such as the melted aluminum onto the outer wall surface even when such a material crawls up along the inner wall surface of the PBN container 10 (hearth liner). Difference between the surface roughness Ra on the outer wall side and the surface roughness Ra on the inner wall side of the container body 11 is preferably 0.1 µm or more and 4.5 µm or less, and more preferably 0.5 µm or more and 4.0 µm or less.

Moreover, in the inventive PBN container 10, it is preferable that an angle θ' between the inner wall surface 14 or the outer wall surface 15 of the container body 11 and an axis of symmetry of the container body is 0.5° or more and 60° or less. This optimizes the amount of the evaporation materials such as the melted aluminum that crawls up along the inner wall surface of the PBN container10 (hearth liner), and improves quality of products. This angle θ' is preferably 0.5° or more and 60° or less, more preferably 1.0° or more and 5.0° or less, and particularly preferably 2.0° or more and 4.0° or less.

Moreover, the inventive PBN container 10 is preferably a PBN hearth liner for electron beam evaporation. The inventive PBN container is remarkably durable as described above. Therefore, when used as the PBN hearth liner for electron beam evaporation, uniform high-purity metal films of large-area can be made for a long time. In addition, because it is hardly broken and has a long life, a decrease in an availability ratio of the apparatus due to exchanges of it is prevented. Thus, cost reduction effect is obtained.

Moreover, in the inventive PBN container 10, the conductive film 12 is preferably pyrolytic graphite (PG). The pyrolytic graphite (PG), like PBN, can easily be made into a high-purity film by a CVD method, etc., and it hardly reacts with the filled material such as melted metal. Also, PG has excellent electrical conductivity. In addition, PG has little risk of contaminating the filled material, and charge-up is certainly prevented. From these, PG is suitable as the conductive film 12 of the PBN container 10.

Moreover, it is preferable that the conductive film 12 has a thickness of 5 µm or more and 100 µm or less. When the conductive film 12 has a thickness of 5 µm or more, it is possible to prevent melted metal such as aluminum from penetrating a PBN base material and improve the durability of the PBN container 10. On the other hand, when the film thickness is 100 µm or less, it is possible to suppress peeling off between PG and PBN due to the difference in thermal expansion coefficient and improve yield. Therefore, the thickness of the conductive film 12 is preferably 5 µm or more and 100 µm or less, more preferably 10 µm or more and 30 µm or less, and particularly preferably 15 µm or more and 25 µm or less.

Note that, in the above description, a case where the inventive PBN container is used for the hearth liner for electron beam evaporation is explained as an example, the PBN container may also be used for a container for MBE (molecular beam epitaxy), a container for melted metal, a container for analysis, and other containers.

The present invention provides a method for producing a PBN container, which can produce the PBN container 10 described above. That is, a method for producing a PBN container, the method comprising the steps of:
forming a container body by laminating pyrolytic boron nitride and processing a shape thereof; and
laminating a conductive film on a surface of the container body, wherein
in the step of forming a container body, an angle θ between a cut face of the container body and an inner wall surface or an outer wall surface of the container body adjacent to the cut face is 20° or more and 80° or less across an entire circumference of an aperture of the container body, and a tip portion of the aperture of the container body has a shape having a curvature radius R of 0.2 mm or more and 3.0 mm or less across the entire circumference of the aperture of the container body.

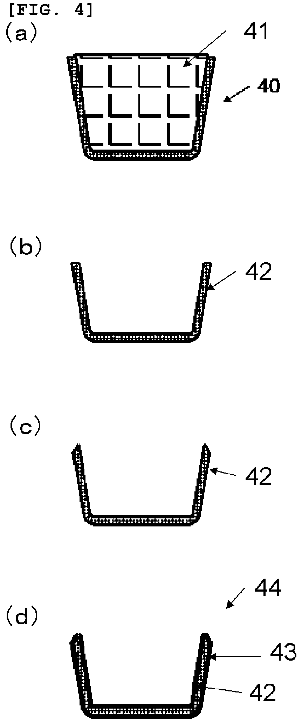

Such an inventive method for producing a PBN container can be performed, for example, in the following way (FIG. 4). The step of forming the container body by laminating pyrolytic boron nitride and processing a shape can be performed in the following way. First, a heat-resistant base material 41 that is formed to obtain a container of a desired shape is prepared, and a PBN layer 40 is laminated on the heat-resistant base material 41 by depositing the PBN using the CVD method, etc. After the deposition reaction is completed, the base material 41 is cooled to room temperature and taken out from a furnace (FIG. 4 (a)). During cooling, a gap is generated between the heat-resistant base material 41 and the PBN layer 40 due to the difference in respective thermal expansion coefficients. Using this gap, the PBN layer 40 can be pulled out from the heat-resistant base material 41 and separated. Then, the PBN layer 40 that has been pulled out is cut to an appropriate height to obtain a container body 42 (FIG 4 (b)). Moreover, as shown in FIG. 4 (c), a cut face of the produced container body 42 is processed so as to satisfy the angle θ and the curvature radius R of the R portion of the container body in the inventive PBN container 10 by processing. Here, the cut face of the container body 42 may be machine-processed to form an angle of 20° to 80° between the cut face and the inner wall surface, and alternatively, may be processed to form an angle of 20° to 80° between the cut face of the container body 42 and the outer wall surface.

In addition, after processing the cut face, the body 42 is placed in the CVD furnace again, and a surface of the body 42 is coated with the conductive film 43 (FIG. 4 (d)). If PG is coated as the conductive film 43, a gas that serves as a carbon source, such as carbon hydride and carbon chloride, may be introduced in the CVD furnace.

In this way, the PBN container 10 shown in FIG. 1 can be produced.

### EXAMPLE

Hereinafter, the present invention will be specifically described showing Examples and Comparative Examples. However, the present invention is not limited to Examples described below.

### (Example 1)

A tapered columnar carbon mold 41 having a diameter of 50 mm and an angle θ' (the angle θ' between a surface that defines an inner wall surface of a container body and an axis of symmetry of the mold) of 3.0° was placed in a CVD furnace, and a temperature was kept at 1900°C. Ammonia as a nitrogen source and boron trichloride as a material gas that serves as a boron source were introduced at 3 L/min and 1 L/min, respectively, to deposit a PBN layer 40 of a thickness of 1 mm (FIG. 4 (a)). Then, after cooling, the deposited PBN layer 40 was pulled out from the carbon mold 41 and was cut to have a height of 25 mm, and thereby a body 42 was made (FIG. 4 (b)).

Subsequently, the cut face of the produced body 42 was processed and polished so that an angle between the cut face and the inner wall surface adjacent to the cut face became 80°, an R-shape of the inner wall tip was 0.5 mm, a length of a flat surface of the tip was 0.2 mm, a surface roughness was 2.0 µm on the inner wall surface, and 1.5 µm on an outer wall surface (FIG. 4 (c)). After processing and polishing, the body 42 was placed in the CVD furnace again and kept at 2000°C, and propane gas that serves as a carbon source was introduced at 3 L/min to deposit a PG layer 43 having a thickness of 30 µm on the surface of the body 42 (FIG. 4 (d). When a density of the body 42 was calculated by a water displacement method, the density thereof was 1.9 g/cm³.

A PBN hearth liner 44 produced as described above was actually used for electron beam evaporation. Namely, 10 g of aluminum was filled in the PBN hearth liner, and an electron beam was irradiated, while being swept, to the aluminum, and thereby, a thin film of aluminum was formed on a substrate. When the amount of the aluminum filled in the PBN hearth liner became half, aluminum was filled again, and the PBN hearth liner was used for forming a thin film of aluminum again. When the number of times of the use reached 105 by repeating the above process, seepage of aluminum was found from the upper end surface of the container.

### (Example 2)

A PBN hearth liner was produced in the same manner as Example 1 except that a cut face of a body was processed and polished so that an angle between the cut face and an inner wall surface adjacent to the cut face became 50°. A result of evaluation thereof is shown in Table 1.

### (Example 3)

A PBN hearth liner was produced in the same manner as Example 1 except that a cut face of a body was processed and polished so that an angle between the cut face and an inner wall surface adjacent to the cut face became 20°. A result of evaluation thereof is shown in Table 1.

### (Example 4)

A PBN hearth liner was produced in the same manner as Example 2 except that a cut face of a body was processed and polished so that an R-shape of an inner wall tip became 0.2 mm. A result of evaluation thereof is shown in Table 1.

### (Example 5)

A PBN hearth liner was produced in the same manner as Example 2 except that a cut face of a body was processed and polished so that an R-shape of an inner wall tip became 3.0 mm. A result of evaluation thereof is shown in Table 1.

### (Example 6)

A PBN hearth liner was produced in the same manner as Example 2 except that a cut face of a body was processed and polished so that a length of a flat surface of a tip became 0.1 mm. A result of evaluation thereof is shown in Table 1.

### (Example 7)

A PBN hearth liner was produced in the same manner as Example 2 except that a cut face of a body was processed and polished so that a length of a flat surface of a tip became 3.0 mm. A result of evaluation thereof is shown in Table 1.

### (Example 8)

A PBN hearth liner was produced in the same manner as Example 2 except that a reaction condition was adjusted so that a density of a body became 1.7 g/cm³. A result of evaluation thereof is shown in Table 1.

### (Example 9)

A PBN hearth liner was produced in the same manner as Example 2 except that a reaction condition was adjusted so that a density of a body became 2.2 g/cm³. A result of evaluation thereof is shown in Table 1.

### (Example 10)

A PBN hearth liner was produced in the same manner as Example 2 except that a cut face of a body was processed and polished so that a surface roughness was 1.0 µm on an inner wall surface, and 0.5 µm on an outer wall surface. A result of evaluation thereof is shown in Table 1.

### (Example 11)

A PBN hearth liner was produced in the same manner as Example 2 except that a cut face of a body was processed and polished so that a surface roughness was 5.0 µm on an inner wall surface, and 4.5 µm on an outer wall surface. A result of evaluation thereof is shown in Table 1.

### (Example 12)

A PBN hearth liner was produced in the same manner as Example 2 except that a reaction was performed by changing a mold to a columnar carbon mold 41 having a diameter of 50 mm and an angle θ' (the angle θ' between a surface that defines an inner wall surface of a container body and an axis of symmetry of the mold) of 0.5°. A result of evaluation thereof is shown in Table 1.

### (Example 13)

A PBN hearth liner was produced in the same manner as Example 2 except that a reaction was performed by changing a mold to a columnar carbon mold 41 having a diameter of 50 mm and an angle θ' (the angle θ' between a surface that defines an inner wall surface of a container body and an axis of symmetry of the mold) of 60°. A result of evaluation thereof is shown in Table 1.

### (Example 14)

A PBN hearth liner was produced in the same manner as Example 2 except that after processing and polishing, a body 42 was placed in a CVD furnace again and kept at 2000°C, propane gas that serves as a carbon source was introduced at 3 L/min, and reaction time was adjusted to deposit a PG layer 43 having a thickness of 5 µm on a surface of the body 42. A result of evaluation thereof is shown in Table 1.

### (Example 15)

A PBN hearth liner was produced in the same manner as Example 2 except that after processing and polishing, a body 42 was placed in a CVD furnace again and kept at 2000°C, propane gas that serves as a carbon source was introduced at 3 L/min, and reaction time was adjusted to deposit a PG layer 43 having a thickness of 100 µm on a surface of the body 42. A result of evaluation thereof is shown in Table 1.

### (Comparative Example 1)

A PBN hearth liner was produced in the same manner as Example 2 except that a cut face of a body was processed and polished so that an R-shape of the inner wall tip became 0 mm. A result of evaluation thereof is shown in Table 1.

### (Comparative Example 2)

A PBN hearth liner was produced in the same manner as Example 2 except that a reaction was performed by changing a mold to a columnar carbon mold 41 having a diameter of 50 mm and an angle in which a cut face was parallel to a central axis; a density of a body became 1.5 g/cm³ by adjusting reaction conditions; a cut face of a body was processed and polished so that an R-shape of the inner wall tip was 0 mm and a surface roughness was 0.1 µm on both an inner wall surface and an outer wall surface; and reaction time was adjusted to deposit a PG layer 43 having a thickness of 2 µm. A result of evaluation thereof is shown in Table 1.

The results of Examples 1 to 15 and Comparative Examples 1 and 2 are summarized in Table 1 below.

**[Table 1]**

| | Angle θ of cut face | R-shape of inner wall tip | Length of flat surface of tip | Density (g/cm³) | Surface roughness Ra (µm) | | Angle θ' | PG film thickness µm | Number of uses | State |
|---|---|---|---|---|---|---|---|---|---|---|
| | | | | | Inner wall | Outer wall | | | | |
| Example 1 | 80° | 0.5mm | 0.2mm | 1.9 | 2.0 | 1.5 | 3° | 30 | 105 | Seepage from upper end |
| Example 2 | 50° | 0.5mm | 0.2mm | 1.9 | 2.0 | 1.5 | 3° | 30 | 258 | Seepage from upper end |
| Example 3 | 20° | 0.5mm | 0.2mm | 1.9 | 2.0 | 1.5 | 3° | 30 | 117 | Top end surface chipped, aluminum leakage |
| Example 4 | 50° | 0.2mm | 0.2mm | 1.9 | 2.0 | 1.5 | 3° | 30 | 252 | Top end surface chipped, seepage |
| Example 5 | 50° | 3.0mm | 0.2mm | 1.9 | 2.0 | 1.5 | 3° | 30 | 195 | Seepage from upper end |
| Example 6 | 50° | 0.5mm | 0.1mm | 1.9 | 2.0 | 1.5 | 3° | 30 | 243 | Top end surface chipped, aluminum leakage |
| Example 7 | 50° | 0.5mm | 3.0mm | 1.9 | 2.0 | 1.5 | 3° | 30 | 135 | Seepage from upper end |
| Example 8 | 50° | 0.5mm | 0.2mm | 1.7 | 2.0 | 1.5 | 3° | 30 | 102 | Seepage from upper end |
| Example 9 | 50° | 0.5mm | 0.2mm | 2.2 | 2.0 | 1.5 | 3° | 30 | 240 | Seepage from upper end |
| Example 10 | 50° | 0.5mm | 0.2mm | 1.9 | 1.0 | 0.5 | 3° | 30 | 186 | Seepage from upper end |
| Example 11 | 50° | 0.5mm | 0.2mm | 1.9 | 5.0 | 4.5 | 3° | 30 | 126 | Seepage from upper end |
| Example 12 | 50° | 0.5mm | 0.2mm | 1.9 | 2.0 | 1.5 | 0.5° | 30 | 225 | Seepage from upper end |
| Example 13 | 50° | 0.5mm | 0.2mm | 1.9 | 2.0 | 1.5 | 60° | 30 | 105 | Top end surface chipped, aluminum leakage |
| Example 14 | 50° | 0.5mm | 0.2mm | 1.9 | 2.0 | 1.5 | 3° | 5 | 108 | Seepage from upper end |
| Example 15 | 50° | 0.5mm | 0.2mm | 1.9 | 2.0 | 1.5 | 3° | 100 | 105 | Seepage from upper end |
| Comparative Example 1 | 50° | 0mm | 0mm | 1.9 | 2.0 | 1.5 | 3° | 30 | 86 | Seepage from upper end |
| Comparative Example 2 | 50° | 0mm | 0mm | 1.5 | 0.1 | 0.1 | Parallel | 2 | 5 | Seepage from upper end |

As understood from Table 1, the PBN hearth liners of Examples 1 to 15 were successfully used more than 105 times and thus excellent in durability. Among these, the PBN hearth liner of Example 2 was extremely excellent in durability, which had an angle between the cut face and the inner wall surface adjacent to the cut face was 50°, the R-shape of the tip was 0.5 mm, a length of the flat surface of the tip was 0.2 mm, a density was 1.9 g/cm³, a surface roughness Ra was 2.0 µm on the inner wall surface, and a surface roughness Ra was 1.5 µm on the outer wall surface, an angle θ' (the angle θ' between the surface that defines the inner wall surface of the container body and the axis of symmetry of the mold) was 3°, and the PG had a thickness of 30 µm.

In contrast, a conventional PBN hearth liner (Comparative Example 1) having the R-shape of the tip being 0 mm was successfully used only 86 times and was inferior in durability. Furthermore, the PBN hearth liner of Comparative Example 2 in which other parameters were not optimal was successfully used only 5 times, and thus it was found that the durability thereof was poor.

The present description includes the following embodiments.
[1]: A PBN container comprising:
   a container body made of a laminate of pyrolytic boron nitride; and
   a conductive film coating a surface of the container body, wherein
   an angle θ between a cut face of the container body and an inner wall surface or an outer wall surface of the container body adjacent to the cut face is 20° or more and 80° or less across an entire circumference of an aperture of the container body, and
   a tip portion of the aperture of the container body has a shape having a curvature radius R of 0.2 mm or more and 3.0 mm or less across the entire circumference of the aperture of the container body.
[2]: The PBN container according to the above [1], wherein
   the tip of the aperture of the container body has a flat surface and the flat surface in a radial direction of the container body has a length of 0.05 mm or more and 2 mm or less.
[3]: The PBN container according to the above [1] or [2], wherein
   the container body has a density of 1.7 g/cm³ or more and 2.2 g/cm³ or less.
[4]: The PBN container according to any of the above [1] to [3], wherein
   surface roughness Ra of the container body is in a range of 0.5 µm or more and 5.0 µm or less.
[5]: The PBN container according to any of the above [1] to [4], wherein
   the surface roughness Ra on the outer wall side of the container body is smaller than the surface roughness Ra on the inner wall side of the container body.
[6]: The PBN container according to any of the above [1] to [5], wherein
   an angle θ' between the inner wall surface or the outer wall surface of the container body and an axis of symmetry of the container body is 0.5° or more and 60° or less.
[7]: The PBN container according to any of the above [1] to [6], wherein
   the PBN container is a PBN hearth liner for electron beam evaporation.
[8]: The PBN container according to any of the above [1] to [7], wherein
   the conductive film is pyrolytic graphite.
[9]: The PBN container according to any of the above [1] to [8], wherein
   the conductive film has a thickness of 5 µm or more and 100 µm or less.
[10]: A method for producing a PBN container, the method comprising the steps of:
   forming a container body by laminating pyrolytic boron nitride and processing a shape thereof; and
   laminating a conductive film on a surface of the container body, wherein
   in the step of forming a container body, an angle θ between a cut face of the container body and an inner wall surface or an outer wall surface of the container body adjacent to the cut face is 20° or more and 80° or less across an entire circumference of an aperture of the container body, and a tip portion of the aperture of the container body has a shape having a curvature radius R of 0.2 mm or more and 3.0 mm or less across the entire circumference of the aperture of the container body.
[11]: The method for producing a PBN container according to the above [10], wherein
   the PBN container to be produced is a PBN hearth liner for electron beam evaporation.
[12]: The method for producing a PBN container according to the above [10] or [11], wherein
   the conductive film is pyrolytic graphite.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A PBN container comprising:
a container body made of a laminate of pyrolytic boron nitride; and
a conductive film coating a surface of the container body, wherein
an angle θ between a cut face of the container body and an inner wall surface or an outer wall surface of the container body adjacent to the cut face is 20° or more and 80° or less across an entire circumference of an aperture of the container body, and
a tip portion of the aperture of the container body has a shape having a curvature radius R of 0.2 mm or more and 3.0 mm or less across the entire circumference of the aperture of the container body.

2. The PBN container according to claim 1, wherein
the tip of the aperture of the container body has a flat surface and the flat surface in a radial direction of the container body has a length of 0.05 mm or more and 2 mm or less.

3. The PBN container according to claim 1 or 2, wherein
the container body has a density of 1.7 g/cm³ or more and 2.2 g/cm³ or less.

4. The PBN container according to any of claims 1 to 3, wherein
surface roughness Ra of the container body is in a range of 0.5 µm or more and 5.0 µm or less.

5. The PBN container according to any of claims 1 to 4, wherein
the surface roughness Ra on the outer wall side of the container body is smaller than the surface roughness Ra on the inner wall side of the container body.

6. The PBN container according to any of claims 1 to 5, wherein
an angle θ' between the inner wall surface or the outer wall surface of the container body and an axis of symmetry of the container body is 0.5° or more and 60° or less.

7. The PBN container according to any of claims 1 to 6, wherein
the PBN container is a PBN hearth liner for electron beam evaporation.

8. The PBN container according to any of claims 1 to 7, wherein
the conductive film is pyrolytic graphite.

9. The PBN container according to any of claims 1 to 8, wherein
the conductive film has a thickness of 5 µm or more and 100 µm or less.

10. A method for producing a PBN container, the method comprising the steps of:
forming a container body by laminating pyrolytic boron nitride and processing a shape thereof; and
laminating a conductive film on a surface of the container body, wherein
in the step of forming a container body, an angle θ between a cut face of the container body and an inner wall surface or an outer wall surface of the container body adjacent to the cut face is 20° or more and 80° or less across an entire circumference of an aperture of the container body, and a tip portion of the aperture of the container body has a shape having a curvature radius R of 0.2 mm or more and 3.0 mm or less across the entire circumference of the aperture of the container body.

11. The method for producing a PBN container according to claim 10, wherein
the PBN container to be produced is a PBN hearth liner for electron beam evaporation.

12. The method for producing a PBN container according to claim 10 or 11, wherein
the conductive film is pyrolytic graphite.
